# EUROPÄISCHE PATENTSCHRIFT

(11) **EP 1 366 054 B1**
(45) Veröffentlichungstag und Bekanntmachung des Hinweises auf die Patenterteilung: **06.04.2005**
(21) Anmeldenummer: 02710817.4
(22) Anmeldetag: 30.01.2002
(51) Int. Cl.: C07F 15/00

(54) **VERFAHREN ZUR HERSTELLUNG VON HOCHREINEN, TRIS-ORTHO-METALLIERTEN ORGANO-IRIDIUM-VERBINDUNGEN**
METHOD FOR THE PRODUCTION OF HIGHLY PURE, TRIS-ORTHO-METALATED ORGANO-IRIDIUM COMPOUNDS
PROCEDE DE PRODUCTION DE COMPOSES DU TYPE ORGANO-IRIDIUM TRIS-ORTHO-METALLISE DE GRANDE PURETE

(30) Priorität: 01.02.2001 DE 10104426
(43) Veröffentlichungstag der Anmeldung: 03.12.2003
(73) Patentinhaber: Covion Organic Semiconductors GmbH, 65926 Frankfurt (DE)
(72) Erfinder: STÖSSEL, Philipp, 65929 Frankfurt (DE); SPREITZER, Hubert, 68519 Viernheim (DE); BECKER, Heinrich, 61479 Glashütten (DE)
(74) Vertreter: Luderschmidt, Schüler & Partner
(86) Internationale Anmeldenummer: PCT/EP2002/000920
(87) Internationale Veröffentlichungsnummer: WO 2002/060910

(56) Entgegenhaltungen:
- EP-A- 1 138 746
- EP-A- 1 175 128
- WO-A-01/41512
- WO-A-02/02714
- WO-A-02/15645
- JP-A- 2001 357 977
- DEDEIAN ET AL.: "A New Synthetic Route to the Preparation of a Series of Strong Photoreducing Agents: fac Tris-Ortho-Metalated Complexes of Iridium(III) with Substituted 2-Phenylpyridines" INORGANIC CHEMISTRY, Bd. 30, Nr. 8, 1991, Seiten 1685-1687, XP001070331 in der Anmeldung erwähnt
- COLOMBO ET AL.: "Facial Tris Cyclometalated Rh3+ and Ir3+ Complexes: Their Synthesis, Structure, and Optical Spectroscopic Properties" INORG. CHEM., Bd. 33, Nr. 3, 1994, Seiten 545-550, XP001070333 in der Anmeldung erwähnt
- KING ET AL.: "Excited-State Properties of a Triply Ortho-Metalated Iridium(III) Complex" J. AM. CHEM. SOC., Bd. 107, Nr. 5, 1985, Seiten 1431-1432, XP001069823 in der Anmeldung erwähnt
- HONG ZHI XIE ET AL.: "Reduction of Self-Quenching Effect in Organic Electrophosphorescence Emitting Devices via the Use of Sterically Hindered Spacers in Phosphorescence Molecules" ADV. MATER, Nr. 16, 2001, Seiten 1245-1248, XP002196400
- LAMANSKY ET AL.: "Synthesis and Characterization of Phosphorescent Cyclometalated Iridium Complexes" INORGANIC CHEMISTRY, Bd. 40, Nr. 7, 2001, Seiten 1704-1711, XP002196399
- VLADIMIR V. GRUSHIN ET AL.: "New, efficient electroluminescent materials based on organometallic Ir complexes" CHEM. COMMUN., 2001, Seiten 1494-1495, XP002196401
- SERGEY LAMANSKY: "Molecularly doped polymer light emitting diodes utilizing phosphorescent Pt(II) and Ir(III) dopants" ORGANIC ELECTRONICS, Nr. 2, 2001, Seiten 53-62, XP002196402

## Beschreibung

Metallorganische Verbindungen - speziell Verbindungen der d⁸-Metalle - werden in naher Zukunft als Wirkkomponenten (= Funktionsmaterialien) in einer Reihe von verschiedenartigen Anwendungen, die im weitesten Sinne der Elektronikindustrie zugerechnet werden können, Einsatz als farbgebende Komponenten finden.
Bei den auf rein organischen Komponenten basierenden Organischen-Elektrolumineszenz-Vorrichtungen (allg. Beschreibung des Aufbaus siehe:
US 4,539,507 und US 5,151,629) bzw. deren Einzelbauteilen, den Organischen-Lichtemittierenden-Dioden (OLEDs) ist die Markteinführung bereits erfolgt, wie die erhältlichen Auto-Radios mit "Organischem Disptay" der Firma Pioneer belegen. Weitere derartige Produkte stehen kurz vor der Einführung. Trotzallem sind hier noch deutliche Verbesserungen nötig um diese Displays zu einer echten Konkurrenz zu den derzeit marktbeherrschenden Flüssigkristallanzeigen (LCD) zu machen bzw. diese zu überflügeln.
Eine Entwicklung hierzu, die sich in den letzten beiden Jahren abzeichnet, ist der Einsatz von metallorganischen Komplexen, die Phosphoreszenz statt Fluoreszenz zeigen [M. A. Baldo, S. Lamansky, P. E. Burrows, M. E. Thompson, S. R. Forrest, Applied Physics Letters, **1999,** 75, 4-6].
Aus theoretischen Spin-statistischen Gründen ist unter Verwendung metallorganischer Verbindungen eine bis zu vierfache Energie- und Leistungseffizienz möglich. Ob sich diese neue Entwicklung durchsetzen wird, hängt zum einen stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Als wesentliche Bedingungen für praktische Anwendung sind hier insbesondere eine hohe operative Lebensdauer, eine hohe Stabilität gegenüber Temperaturbelastung und eine niedrige Einsatz- und Betriebsspannung, um mobile Applikationen zu ermöglichen, zu nennen.

Zum anderen muß der effiziente chemische Zugang zu den entsprechenden, hochreinen Organo-Iridium-Verbindungen gegeben sein. Dies ist insbesondere unter Berücksichtigung des Iridiumpreises von maßgebender Bedeutung für die wirtschaftliche Nutzung der genannten Verbindungsklasse.

In der Literatur sind mehrere Verfahren zur Darstellung von tris-ortho-metallierten Organo-Iridium-Verbindungen beschrieben worden. Die allgemeinen Zugangswege, die durch diese erreichten Ausbeuten und ihre Nachteile sind im folgenden kurz am Grundkörper der genannten Verbindungsklasse, dem *fac*-Tris[2-(2-pyridinyl-κN)phenyl-κC]-iridium(III), dargelegt.

Ausgehend von hydratisiertem tridium(III)chlorid und 2-Phenylpyridin wurde *fac*-Tris[2-(2-pyridinyl-κN)phenyl-κC]-iridium(III), nach aufwendigen chromatographischen Reinigungsverfahren, in etwa 10% iger Ausbeute erhalten [K. A. King, P. J. Spellane, R. J. Watts, J. Am. Chem. Soc., **1985**, *107*, 1431-1432].

K. Dedeian et al. beschreiben ein Verfahren ausgehend von Iridium(III)-acetylacetonat und 2-Phenylpyridin nach dem *fac*-Tris[2-(2-pyddinyl-κN)phenyl-κC]-iridium(III) in 45% iger Ausbeute erhalten wurde. Analog zum oben genannten Verfahren muß auch bei diesem Verfahren das Produkt durch chromatographische Verfahren von Verunreinigungen befreit werden, wobei hier - bedingt durch das Löslichkeitsverhalten - halogenierte Kohlenwasserstoffe zum Einsatz kommen [K. Dedeian, P. I. Djurovich, F. O. Garces, G. Carlson, R. J. Watts Inorg. Chem., **1991**, *30*, 1685-1687].

In einem dritten literaturbekannten Verfahren wird Di-µ-chlorotetrakis[2-(2-pyridinyl-κN)phenyl- κC]di-iridium(III), welches zunächst in ca. 72%-iger Ausbeute aus hydratisiertem Iridium(III)-chlorid und 2-Phenylpyridin dargestellt werden muß [S. Spouse, K. A. King, P. J. Spellane, R. J. Watts J. Am. Chem. Soc., **1984**, *106*, 6647], als Edukt verwendet. Diese wird dann mit 2-Phenylpyridin und zweifach molaren Mengen an Silber-trifluormethansulfonat bezogen auf das Di-µchlorotetrakis[2-(2-pyridinyl- κN)phenyl- κC]di-iridium(III) umgesetzt. Nach chromatographischer Aufeinigung erhalten die Autoren Tris[2-(2-pyridinyl-κN)phenyl-κC]-iridium(III) in 75% iger Ausbeute [M. G. Colombo, T. C. Brunold, T. Riedener, H. U. Güdel Inorg. Chem., **1994**, *33*, 545-550]: Neben der chromatographischen Aufreinigung, die wiederum mit Hilfe von halogenierten Kohenwasserstoffen erfolgt, ist die Verwendung von zweifach molaren Mengen an Silber-trifluormethansulfonat bezogen auf das Di-µ-chlorotetrakis[2-(2-pyridinyl- κN)phenyl- κC]di-iridium(III) nachteilig.

In der nachfolgend aufgeführten Tabelle sind diese Literaturangaben zur besseren Übersicht gegenübergestellt, inklusive des in Beispiel 1 durchgeführten Vergleichsexperiments.

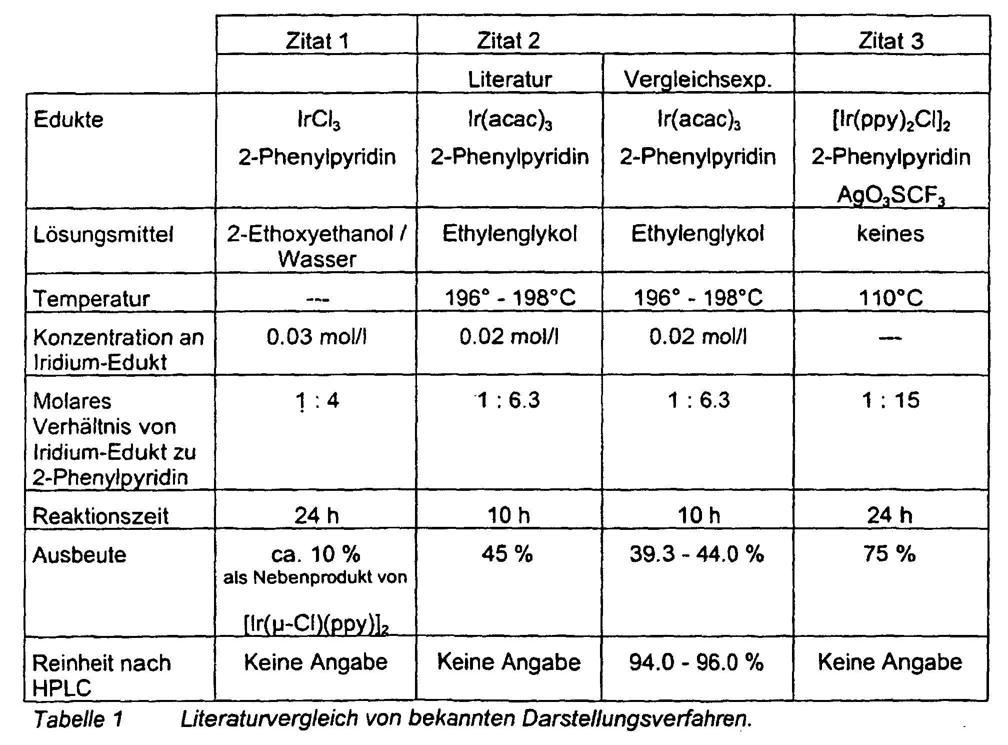

- Zitat 1:: K. A. King, P. J. Spellane, R. J. Watts, J. Am. Chem. Soc., **1985,** *107*, 1431 - 1432. S. Spouse, K. A. King, P. J. Spellane, R. J. Watts, J. Am. Chem. Soc., **1984,** *106,* 6647 - 6653.
- Zitat 2:: K. Dedeian, P. I. Djurovich, F. O. Garces, G. Carlson, R. J. Watts Inorg. Chem., **1991,** *30*, 1685-1687.
- Zitat3:: M. G. Colombo, T. C. Brunold, T. Riedener, H. U. Güdel Inorg. Chem., **1994,** *33*, 545-550.

Es wurde nun überraschend gefunden, daß Verbindungen I - gemäß Schema 1 - ausgehend von Iridium(III)-acetylacetonat oder ähnlichen 1,3-Diketo-chelatkomplexen und 2-Arylpyridinen, unter geeigneter Wahl der Reaktionsparameter wie Reaktionstemperatur, Konzentrationen und Reaktionszeiten, reproduzierbar in etwa 90 bis 95% iger Ausbeute, ohne die Verwendung chromatographischer Reinigungsverfahren, in Reinheiten von > 99.9% nach HPLC, erhalten werden (siehe Verfahren A, Beispiel 2 bis 5).

Gegenstand der vorliegenden Erfindung ist ein Verfahren zur Herstellung von Verbindungen I 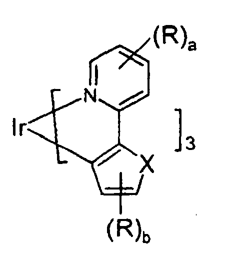 worin
- X: ist gleich -CH=CH-, -CR=CH-, -CR=CR-, N-H, N-R¹, O, S oder Se; bevorzugt -CH=CH-, -CR=CH- oder S;
- R: ist gleich oder verschieden bei jedem Auftreten F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder-CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
- R¹ und R²: sind gleich oder verschieden, H oder ein aliphatischer oder aromatischer Kohlenwasserstoffrest mit 1 bis 20 C-Atomen,
- a: ist 0, 1, 2, 3 oder 4, bevorzugt 0 oder 1,
- b: ist 0, 1 oder 2, bevorzugt 0 oder 1,
durch Umsetzung einer Verbindung der Formel (Ia) 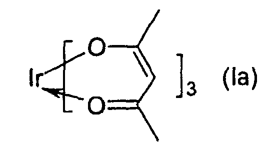 mit einer Verbindung der Formel (Ib) 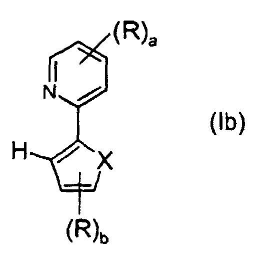 worin die Reste X, R, a und b die unter Formel (I) genannten Bedeutungen haben, in einem dipolar protisches Lösemittel, ein davon abgeleitetes verethertes Derivat oder N-Methyl-pyrrolidinon (NMP), bei Temperaturen im Bereich von 160 bis 220°C und einer Konzentration des iridium-haltigen Edukts (bezogen auf Iridium) im Bereich von 0.05 bis 1.00 mol/l und wobei die Konzentration des eingesetzten Liganden (Aryl-pyridyl-Derivat) einen Faktor 4 bis 20 höher als die des Iridium-haltigen Edukts ist für eine Dauer von 20 bis 100 Stunden.

Das erfindungsgemäße Verfahren wird durch das Schema 1 erläutert.

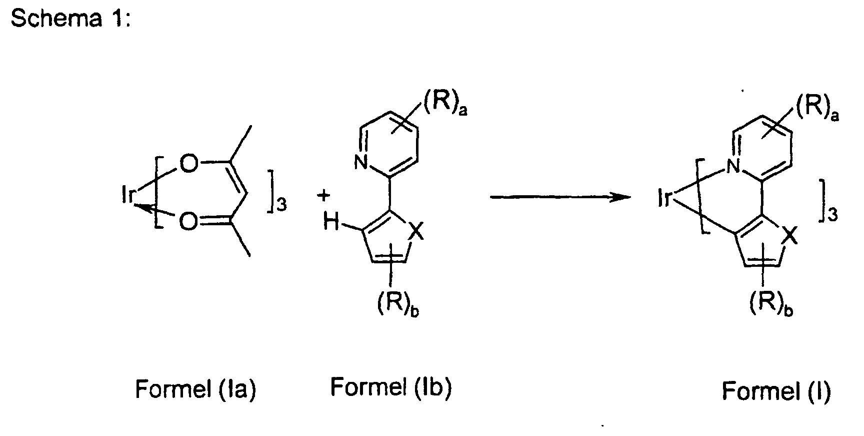

Erfindungsgemäße Reaktionsmedien sind hochsiedende dipolar-protische Lösungsmittel wie Ethylenglykol oder Propylenglykol, bzw. auch höhere Diole oder Polyalkohole, wie z.B. Glycerin, bzw. auch Polyether-alkohole wie Polyethylenglykole, beispielsweise PEG600 und PEG1000, sowie deren veretherte Analoga wie z.B. Triethylenglykoldimethylether oder Poly-(ethylenglykol)-dimethylether, sowie NMP.
Erfindungsgemäß wird die Umsetzung in einem Temperaturbereich von 160°C bis 220°C, bevorzugt im Bereich von 180°C bis 210°C durchgeführt.
Erfindungsgemäß liegt die Konzentration des Iridium-haltigen Edukts, Iridium(III)-acetylacetonat oder eines ähnlichen 1,3-Diketo-chelat-komplexes, im Bereich von 0.05 bis 1.00 molar, bevorzugte im Bereich von 0.08 bis 0.25 molar.
Das erfindungsgemäße molare Verhältnis des Iridium-haltigen Edukts, Iridium(III)-acetylacetonat oder eines ähnlichen 1,3-Diketo-chelat-komplexes, zum Aryl-pyridyl-Derivat beträgt 1:4 bis 1: 20, bevorzugt ist ein Verhältnis von 1:6 bis 1:15, besonders bevorzugt ist ein Verhältnis von 1:8 bis 1:12.
Die bevorzugte Konzentration des Aryl-pyridyl-Derivats liegt im Bereich von 0.50 bis 10.00 molar, besonders bevorzugt im Bereich von 0.80 bis 2.50 molar.
Eine Unterschreitung der oben genannten Konzentrationen führt neben geringerem Umsatz zur Bildung von braunen Nebenprodukten, und damit zur Verunreinigung des Produkts.
Erfindungsgemäß wird die Reaktion innerhalb von 20 bis 100 h durchgeführt, bevorzugt im Bereich von 30 bis 80 h. Eine Unterschreitung der genannten Reaktionszeit hat einen unvollständigen Umsatz des eingesetzten Iridium-haltigen Edukts, Iridium(III)-acetylacetonat oder eines ähnlichen 1,3-Diketo-chelat-komplexes, zur Folge, was zu Ausbeuteverlusten und zu Verunreinigung des Produkts mit Iridium(III)-acetytacetonat oder mit einem ähnlichen 1,3-Diketo-chetatkomplex führt.

Des weiteren wurde überraschend gefunden, daß Verbindungen der Formel (II) ausgehend von Iridium(III)-Verbindungen und "in situ" erzeugtem 2'-Lithio-2-arylpyridinen, in einer salzmetathetischen Umsetzung bei tiefen Temperaturen, reproduzierbar in etwa 85 bis 92% Ausbeute, ohne die Verwendung chromatographischer Reinigungsverfahren, in Reinheiten von > 99.9% nach HPLC, erhalten werden (siehe Schema 2; Verfahren B, Beispiele 6 bis 8).

Ein weiterer Gegenstand der vorliegenden Erfindung ist ein Verfahren zur Herstellung von Verbindungen (II) 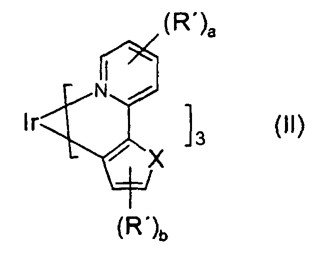 worin
- X: ist gleich -CH=CH-, -CR=CH-, -CR=CR-, N-H, N-R¹, O, S oder Se; bevorzugt -CH=CH-, -CR=CH- oder S;
- R': ist gleich oder verschieden bei jedem F, eine geradkettige oder verzweigte oder cyclische Alkylgruppe mit 1 bis 20 C-Atomen, wobei ein oder mehrere H-Atome durch F ersetzt sein können, oder eine Arylgruppe mit 6 bis 14 C-Atomen, die durch einen oder mehrere, nicht aromatische Reste R' substituiert sein kann; wobei mehrere Substituenten R', sowohl am selben Ring als auch an den beiden unterschiedlichen Ringen zusammen wiederum ein weiteres mono- oder polycyclisches Ringsystem aufspannen können;
- R¹: gleich oder verschieden ein aliphatischer oder aromatischer Kohlenwasserstoffrest mit 1 bis 20 C-Atomen ist,
- a: ist 0, 1, 2, 3 oder 4, bevorzugt 0 oder 1,
- b: ist 0, 1 oder 2, bevorzugt 0 oder 1,
durch Umsetzung einer Verbindung der Formel (IIb) 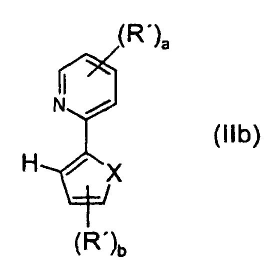 worin die Reste X, R', a und b die vorstehend genannten Bedeutungen haben, mit einer metallorganischen Lithiumverbindung zu einer Verbindung der Formel (IIc) 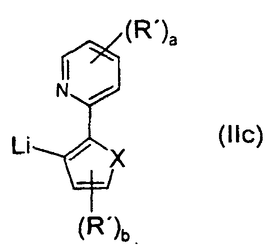 und nachfolgender Umsetzung der Verbindung der Formel (IIc) mit einer Ir(III)-Verbindung bei tiefen Temperaturen zur Zielverbindung der Formel (II).

Erfindungsgemäß werden als Ir(III)-Verbindung Iridium(III)-halogenide bzw. - pseudohalogenide, wie Cyanide, Thiocyanate und Cyanate und davon abgeleitete Komplexe, bevorzugt Iridium(III)-chlorid, Tris-(pyridin)-iridium(III)-chlorid und Tris-(tetrahydrothiophen)-iridium(III)-chlorid, eingesetzt.
Des weiteren ist erfindungsgemäß die Verwendung eines "in-situ" hergestellten 2'-Lithio-2-arylpyridyl-derivats.

Erfindungsgemäß wird die Umsetzung bei tiefen Temperaturen, bevorzugt im Bereich von -110 bis +10°C, besonders bevorzugt im Bereich von -110 bis -20°C, ganz besonders bevorzugt im Bereich von -90 bis -40°C durchgeführt. Labortechnisch erweist sich die Umsetzung bei -78°C (Verwendung eines Aceton/Trockeneis-Kühlbades) als günstig.

Die Umsetzung wird wie im folgenden beschrieben durchgeführt:
Es wird das 2-Arylpyridin oder eine analoge Vorstufe gemäß nachfolgendem Schema 2 zunächst bei tiefen Temperaturen durch Einwirkung von Lithium-Organylen wie z. B. *n-, sec-* oder *tert*-Butyllithium selektiv in 2'-Stellung deprotoniert (Schritt 1), wobei der Zusatz von TMEDA (N,N,N',N'-Tetramethylethylen-1,2-diamin), 2-Hydoxyethyl-dimethyl-amin oder Analogen, dem Fachmann bekannten Aktivatoren vorteilhaft sein kann. Die so erzeugte Aryllithium-Spezies regiert dann in einem zweiten Schritt im Sinne einer salzmetathetischen Umsetzung mit den oben genannten Iridium-(III)-Verbindungen (Schritt 2).
Dieses Verfahren ist dann besonders vorteilhaft, wenn des eingesetzte, substituierte 2-Arylpyridin thermisch labile Gruppen trägt und aus diesem Grund Verfahren A, das sehr viel höhere Temperaturen verwendet, nicht eingesetzt werden kann.

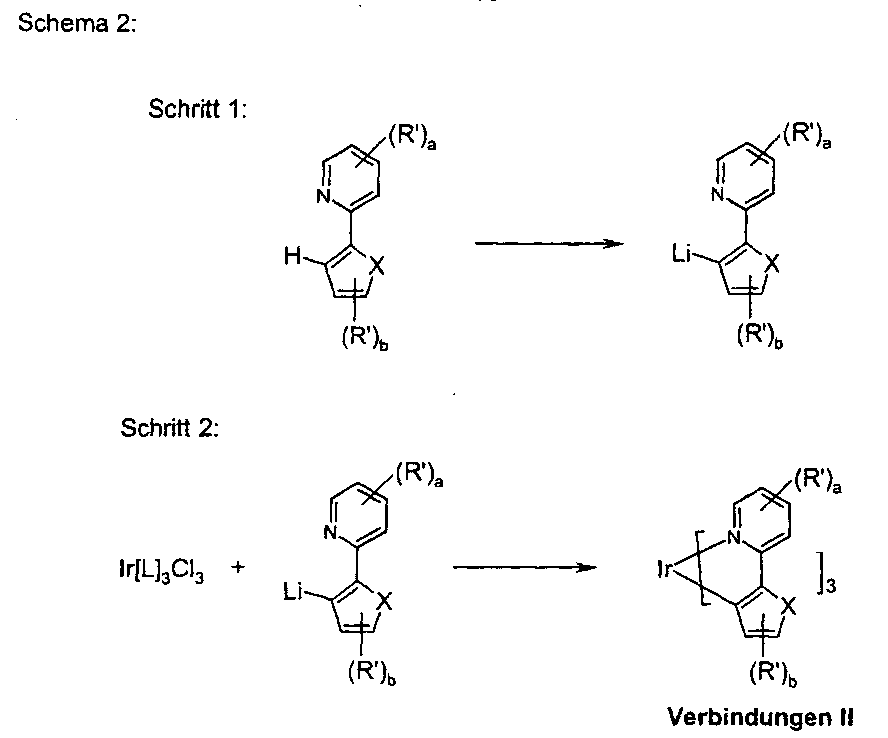

Wobei die Symbole und Indizes die bereits oben für Verbindung (II) angegebenen Bedeutungen besitzen.

Die im Stand der Technik beschriebenen Verbindungen der Formel (I) und (II) sind bislang maximal in Reinheiten von bis zu 96 % zugänglich gewesen. Durch die erfindungsgemäße Herstellung können jedoch Verbindungen der Formel (I) und (II) in Reinheiten von mehr als 99%, bevorzugt von mehr als 99,9 %, halten werden. Derartig reine Verbindungen waren bislang im Stand der Technik nicht bekannt und sind daher ebenfalls Gegenstand der vorliegenden Erfindung.
Die vorliegende Erfindung wird durch die nachfolgenden Beispiele näher erläutert, ohne jedoch diese auf die Beispiele einschränken zu wollen. Dem Fachmann auf dem Gebiet der organischen Synthese sollte es hiermit ohne weitere erfinderische Tätigkeit möglich sein, an weiteren Systemen - wie oben beschrieben - die erfindungsgemäßen Umsetzungen durchzuführen.

### 1. Synthese von tris-ortho-metallierten Organo-Iridium-Verbindungen:

Die nachfolgenden Synthesen wurden bis zur Aufarbeitung unter einer trockenen Rein-Stickstoffatmosphäre oder -Argonatmosphäre unter Verwendung sorgfältig getrockneter Lösungsmittel durchgeführt. Die verwendeten Edukte wurden bei ALDRICH [*n*-Butyllithium 1:6 molar in *n*-Hexan, Ethylenglykol, Triethylenglykoldimethylether, Polyethylenglykol 600 bzw. 1000, Iridium(III)-chlorid, Iridium(III)-acetylacetonat, Tris-(pyridin)-iridium(III)-chlorid] bezogen und ohne weitere Reinigung verwendet bzw. nach literaturbekannten Verfahren [Tris-(tetrahydrothiophen)-iridium(III)-chlorid: L. Mønsted, O. Mønsted, G. Nord, K. Simonsen Acta Chem Scand., **1993,** *47,* 439-443; 2-(4',5'-difluorphenyl)-pyridin: analog zu E. I. Negeshi, F. T. Luo, R. Frisbee, H. Matsushita Heterocycles, **1982,** *18*, 117] hergestellt.

### Verfahren A

### Beispiel 1: fac-Tris[2-(2-pyridinyl-κN)phenyl-κC]-iridium(III)

### Vergleichsbeispiel nach: K. Dedeian, P. I. Djurovich, F. O. Garces, G. Carlson, R. J. Watts Inorg. Chem., 1991, 30, 1685-1687)

Zu 500 ml entgastem Ethylenglykol wurden 4.90 g (10.0 mmol) Iridium(III)-acetylacetonat und 9.77 g = 9.0 ml (63 mmol) 2-Phenylpyridin gefügt. Die Suspension wurde unter gutem Rühren 10 h unter Rückfluß (200°-210°C Ölbadtemperatur) erhitzt. Nach Abkühlen auf Raumtemperatur wurde die Reaktionsmischung, unter Rühren mit 3000 ml wäßriger 1 N Salzsäure versetzt. Nach 5 minütigem Rühren wurde der gelbe Niederschlag über eine Glasfiltemutsche (P3) abgesaugt. Das Rohprodukt wurde in 2000 ml siedendem Dichlormethan aufgenommen, der unlösliche Rückstand wurde abflitriert und zwei mal mit 200 ml Dichlormethan gewaschen. Das Filtrat wurde durch Flash-Chromatographie an Kieselgel von braunen Nebenprodukten befreit. Nach Zugabe von 500 ml Methanol zum Filtrat wurde das Dichlormethan abdestilliert. Dabei fiel ein gelbes, mikrokristallines Pulver an.
Die Ausbeute - bei einer Reinheit von 94.0-96.0% nach HPLC - betrug 2,57 - 2.88 g entsprechend 39.3 - 44.0 %.

### Beispiel 2 fac-Tris[2-(2-pyridinyl-κN)phenyl-κC]-iridium(III)

Zu 100 ml entgastem Ethylenglykol wurden 4.90 g (10.0 mmol) Iridium(III)-acetylacetonat und 15.52 g = 14.0 ml (100 mmol) 2-Phenylpyridin gefügt. Die Suspension wurde unter gutem Rühren 60 h unter Rückfluß (200°-210°C Ölbadtemperatur) erhitzt. Nach Abkühlen auf Raumtemperatur wurde die Reaktionsmischung, die das Produkt *fac*-Tris[2-(2-pyridinyl-κN)phenyl-κC]-iridium(III) in Form eines gelben, feinkristallinen Niederschlags enthielt, unter Rühren in 200 ml wäßrige 1 N Salzsäure eingegossen. Nach 5 minütigem Rühren wurde über eine Glasfilternutsche (P3) abgesaugt, der gelbe, feinkristalline Niederschlag wurde drei mal mit 30 ml wäßriger 1 N Salzsäure und fünf mal mit 30 ml Wasser gewaschen und anschießend im Hochvakuum 5 h bei 80° und 2 h 200°C getrocknet.
Die Ausbeute - bei einer Reinheit von > 99.9% nach HPLC - betrug 6.04 - 6.29 g entsprechend 92.2 - 96.0 %.
¹H NMR (CDCl₃): [ppm] = 7.84 (m, 3 H), 7.58 (m, 6 H), 7.48 (m, 3 H), 6.82 (m, 6 H), 6.69 (m, 6 H).

### Beispiel 3 fac-Tris[2-(2-pyridinyl-κN)phenyl-κC]-iridium(III)

Durchführung analog zu Beispiel 2, wobei Ethylenglykol durch Triethylenglykoldimethylether ersetzt wurde.
Die Ausbeute - bei einer Reinheit von > 99.9% nach HPLC - betrug 5.90 - 6.13 g entsprechend 90.1 - 93.6 %.
¹H NMR (CDCl₃): [ppm] = siehe Beispiel 2

### Beispiel 4 fac-Tris[2-(2-pyridinyl-κN)phenyl-κC]-iridium(III)

Eine Mischung von 100 g Polyethylenglykol 600 bzw. altemativ Polyethylenglykol 1000, 4.90 g (10.0 mmol) Iridium(III)-acetylacetonat und 7.76 g = 7.0 ml (50 mmol) 2-Phenylpyridin wurde in einer Crigee-Apparatur aufgeschmolzen und durch Anlegen von Vakuum und Rückfüllen mit Schutzgas (drei Zyklen) entgast.
Die Suspension wurde unter gutem Rühren 30 h auf 180°-200°C erhitzt. Dabei schied sich in der Vorlage sukzessive das freigesetzte Acetylaceton ab. Nach Abkühlen auf 45°C wurde die Reaktionsmischung, die das Produkt *fac*-Tris[2-(2-pyridinyl-κN)phenyl-κC]-iridium(III) in Form eines gelben, feinkristallinen Niederschlags enthielt, unter Rühren in 200 ml wäßrige 1 N Salzsäure eingegossen.

Nach 5 minütigem Rühren wurde über eine Glasfiltemutsche (P3) abgesaugt, der gelbe, feinkristalline Niederschlag wurde drei mal mit 30 ml wäßriger 1 N Salzsäure und fünf mal mit 30 ml Wasser gewaschen und anschießend im Hochvakuum 5 h bei 80° und 2 h 200°C getrocknet.
Die Ausbeute - bei einer Reinheit von > 99.9% nach HPLC - betrug 5.87 - 6.02 g entsprechend 89.6 - 91.9 %.
¹H NMR (CDCl₃): [ppm] = siehe Beispiel 2

### Beispiel 5 fac-Tris[4,5-difluoro-2-(2-pyridinyl-κN)phenyl-κC]-iridium(III)

Zu 80 ml entgastem Ethylenglykol wurden 4.90 g (10.0 mmol) Iridium(III)-acetylacetonat und 19.12 g = (100 mmol) 2-(4',5'-difluorphenyl)pyridin gefügt. Die Suspension wurde unter gutem Rühren 60 h unter Rückfluß (200°-210°C Ölbadtemperatur) erhitzt. Nach Abkühlen auf Raumtemperatur wurde die Reaktionsmischung, die das Produkt *fac*-Tris[4,5-difluoro-2-(2-pyridinyl-κN)phenyl-κC)-iridium(III) in Form eines gelben, feinkristallienen Niederschlags enthielt, unter Rühren in 100 ml wäßrige 1 N Salzsäure eingegossen. Nach 5 minütigem Rühren wurde über eine Glasfiltemutsche (P3) abgesaugt, der gelbe, feinkristalline Niederschlag wurde drei mal mit 30 ml wäßriger 1 N Salzsäure und fünf mal mit 30 ml Wasser gewaschen und anschießend im Hochvakuum 5 h bei 80° und 2 h 200°C getrocknet.
Die Ausbeute - bei einer Reinheit von > 99.9% nach HPLC - betrug 7.13 - 7.37 g entsprechend 93.4 - 96.6 %.
¹H NMR (CDCl₃): [ppm] = 8.35 (m, 3 H), 7.66 (m, 3 H), 7.53 (m, 3 H), 6.93 (m, 3 H), 6.67 (m, 3 H), 6.39 (m, 3 H).

### Verfahren B

### Beispiel 6 fac-Tris(2-(2-pyridinyl-κN)phenyl-κC]-iridium(III)

Eine auf -78°C gekühlten Mischung aus 5.12 g = 4.72 ml (33 mmol) 2-Phenylpyridin und 100 ml THF wurde unter Rühren während 10 min mit 20.6 ml (33 mmol) *n*-Butyllithium 1.6 molar in *n*-Hexan versetzt. Die tiefrote Lösung wurde weitere 1 h bei -78°C gerührt und dann mit 2.99 g wasserfreiem Iridium(III)-chlorid versetzt.
Man ließ die Reaktionsmischung unter Rühren während 12 Stunden auf Raumtemperatur erwärmen. Anschließend wurde das THF am Rotationsverdampfer entfernt, der gelbe, halbfeste Rückstand wurde in 100 ml Ethanol suspendiert und unter Rühren in 200 ml wäßrige 1 N Salzsäure eingegossen. Nach 5 minütigem Rühren wurde über eine Glasfilternutsche (P3) abgesaugt, der gelbe, feinkristalline Niederschlag wurde drei mal mit 30 ml wäßriger 1 N Salzsäure und fünf mal mit 30 ml Wasser gewaschen und anschießend im Hochvakuum 5 h bei 80° und 2 h 200°C getrocknet.
Die Ausbeute - bei einer Reinheit von > 99.9% nach HPLC - betrug 5.66 - 5.79 g entsprechend 86.4 - 88.4 %.
¹H NMR (CDCl₃): [ppm] = siehe Beispiel 2

### Beispiel 7 fac-Tris[2-(2-pyridinyl-κN)phenyl-κC]-iridium(III)

Durchführung analog zu Beispiel 6, wobei das Iridium(III)-chlorid durch 5.36 g (10 mmol) Tris-(pyridin)-iridium(III)-chlorid ersetzt wurde.
Die Ausbeute - bei einer Reinheit von > 99.9% nach HPLC - betrug 5.83 - 6.05 g entsprechend 89.0 - 92.3 %.
¹H NMR (CDCl₃): [ppm] = siehe Beispiel 2

### Beispiel 8 fac-Tris[2-(2-pyridinyl-κN)phenyl-κC]-iridium(III)

Durchführung analog zu Beispiel 6, wobei das Iridium(III)-chlorid durch 5.66 g (10 mmol) Tris-(tetrahydrothiophen)-iridium(III)-chlorid ersetzt wurde.
Die Ausbeute - bei einer Reinheit von > 99.9% nach HPLC - betrug 5.61 - 5.70 g entsprechend 85.7 - 87.0 %.
¹H NMR (CDCl₃): [ppm] = siehe Beispiel 2

## Patentansprüche

1. Verfahren zur Herstellung von Verbindungen der Formel (I) 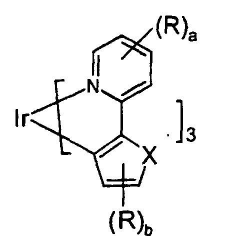 worin
X ist gleich -CH=CH-, -CR=CH-, -CR=CR-, N-H, N-R¹, O, S oder Se;
R ist gleich oder verschieden bei jedem Auftreten F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
R¹ und R² sind gleich oder verschieden, H oder ein aliphatischer oder aromatischer Kohlenwasserstoffrest mit 1 bis 20 C-Atomen,
a ist 0, 1, 2, 3 oder 4,
b ist 0, 1 oder 2,
durch Umsetzung einer Verbindung der Formel (la) 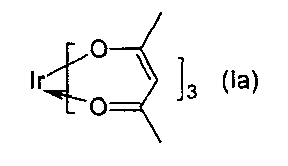 mit einer Verbindung der Formel (Ib) 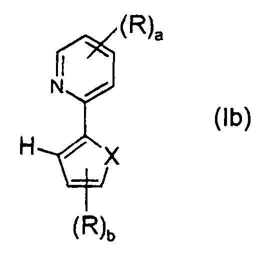 worin die Reste X, R, a und b die unter Formel (I) genannten Bedeutungen haben, in einem dipolar protisches Lösemittel, ein davon abgeleitetes verethertes Derivat oder N-Methyl-pyrrolidinon (NMP), bei Temperaturen im Bereich von 160 bis 220°C und einer Konzentration des Iridium-haltigen Edukts (bezogen auf Iridium) im Bereich von 0.05 bis 1.00 mol/l und wobei die Konzentration des eingesetzten Liganden (Aryl-pyridyl-Derivat) einen Faktor 4 bis 20 höher als die des Iridium-haltigen Edukts ist für eine Dauer von 20 bis 100 Stunden.

2. Verfahren gemäß Anspruch 1, **dadurch gekennzeichnet, daß** als Lösemittel Ethylenglykol, Propylenglykol, Glycerin, PEG600, PEG1000, Triethylenglykoldimethylether, Poly-(ethylenglykol)-dimethylether oder N-Methyl-pyrrolidinon (NMP) verwendet wird.

3. Verfahren gemäß den Ansprüchen 1 und/oder 2, **dadurch gekennzeichnet, daß** die Umsetzung in einem Temperaturbereich von 180°C bis 210°C durchgeführt wird.

4. Verfahren gemäß einem oder mehreren der Ansprüche 1 bis 3, **dadurch gekennzeichnet, daß** die Konzentration des Iridium-haltigen Edukts, Iridium(III)-acetylacetonat oder eines ähnlichen 1,3-Diketo-chelat-komplexes, im Bereich von 0.08 bis 0.25 molar liegt.

5. Verfahren gemäß einem oder mehreren der Ansprüche 1 bis 4, **dadurch gekennzeichnet, daß** das Verhältnis des Iridium-haltigen Edukts, Iridium(III)-acetylacetonat oder eines ähnlichen 1,3-Diketo-chelat-komplexes, zum Aryl-pyridyl-Derivat 1:6 bis 1:15 beträgt.

6. Verfahren gemäß einem oder mehreren der Ansprüche 1 bis 5, **dadurch gekennzeichnet, daß** die Reaktion innerhalb von 30 bis 80 h durchgeführt wird.

7. Verfahren zur Herstellung von Verbindungen der Formel (II) 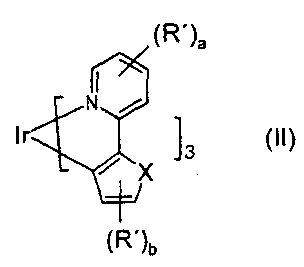 worin
X ist gleich -CH=CH-, -CR=CH-, -CR=CR-, N-H, N-R¹, O, S oder Se;
R' ist gleich oder verschieden bei jedem Auftreten F, eine geradkettige oder verzweigte oder cyclische Alkylgruppe mit 1 bis 20 C-Atomen, wobei ein oder mehrere H-Atome durch F ersetzt sein können, oder eine Arylgruppe mit 6 bis 14 C-Atomen, die durch einen oder mehrere, nicht aromatische Reste R' substituiert sein kann; wobei mehrere Substituenten R', sowohl am selben Ring als auch an den beiden unterschiedlichen Ringen zusammen wiederum ein weiteres mono- oder polycyclisches Ringsystem aufspannen können;
R¹ gleich oder verschieden ein aliphatischer oder aromatischer Kohlenwasserstoffrest mit 1 bis 20 C-Atomen ist,
a ist 0, 1, 2, 3 oder 4,
b ist 0, 1 oder 2,
durch Umsetzung einer Verbindung der Formel (IIb) 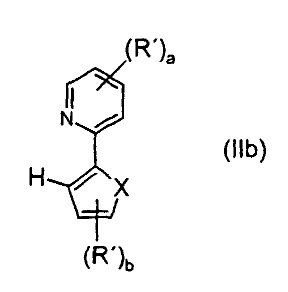 worin die Reste X, R', a und b die vorstehend genannten Bedeutungen haben, mit einer metallorganischen Lithiumverbindung zu einer Verbindung der Formel (IIc) 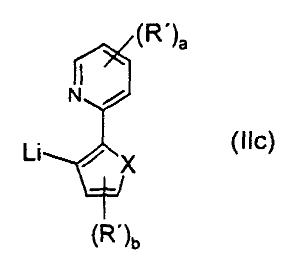 und nachfolgender Umsetzung der Verbindung der Formel (IIc) mit einer Ir(III)-Verbindung bei tiefen Temperaturen zur Zielverbindung der Formel (II).

8. Verfahren gemäß Anspruch 7, **dadurch gekennzeichnet, daß** Iridium(III)-chlorid, Tris-(pyridin)-iridium(III)-chlorid und Tris-(tetrahydrothiophen)-iridium(III)-chlorid verwendet wird.

9. Verfahren gemäß den Ansprüchen 7 und/oder 8, **dadurch gekennzeichnet, daß** das 2'-Lithio-2-arylpyridyl-derivat gemäß Formel (IIc) "in-situ" hergestellt wird.

10. Verfahren gemäß einem oder mehreren der Ansprüche 7 bis 9, **dadurch gekennzeichnet, daß** die Umsetzung im Bereich von -110 bis +10°C durchgeführt wird.

11. Verfahren gemäß Anspruch 10, **dadurch gekennzeichnet, daß** die Umsetzung im Bereich von -110 bis -20°C durchgeführt wird.

12. Verfahren gemäß Anspruch 10, **dadurch gekennzeichnet, daß** die Umsetzung im Bereich von -90 bis -40°C durchgeführt wird.

13. Verbindungen der Formel (I) 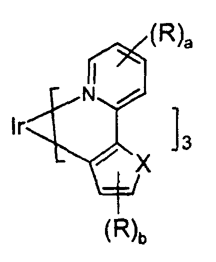 worin
X ist gleich -CH=CH-, -CR=CH-, -CR=CR-, N-H, N-R¹, O, S oder Se;
R ist gleich oder verschieden bei jedem Auftreten F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
R¹ und R² sind gleich oder verschieden, H oder ein aliphatischer oder aromatischer Kohlenwasserstoffrest mit 1 bis 20 C-Atomen,
a ist 0, 1, 2, 3 oder 4,
b ist 0, 1 oder 2,
deren Reinheit (mittels HPLC bestimmt) mehr als 99% beträgt.

14. Verbindungen der Formel (II) 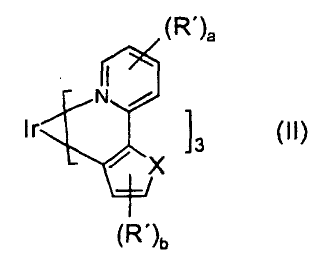 worin
X ist gleich -CH=CH-, -CR=CH-, -CR=CR-, N-H, N-R¹, O, S oder Se;
R' ist gleich oder verschieden bei jedem Auftreten F, eine geradkettige oder verzweigte oder cyclische Alkylgruppe mit 1 bis 20 C-Atomen, wobei ein oder mehrere H-Atome durch F ersetzt sein können, oder eine Arylgruppe mit 6 bis 14 C-Atomen, die durch einen oder mehrere, nicht aromatische Reste R' substituiert sein kann; wobei mehrere Substituenten R', sowohl am selben Ring als auch an den beiden unterschiedlichen Ringen zusammen wiederum ein weiteres mono- oder polycyclisches Ringsystem aufspannen können;
R¹ gleich oder verschieden ein aliphatischer oder aromatischer Kohlenwasserstoffrest mit 1 bis 20 C-Atomen ist,
a ist 0, 1, 2, 3 oder 4,
b ist 0, 1 oder 2,
deren Reinheit (mittels HPLC bestimmt) mehr als 99% beträgt.

## Claims

1. A process for preparing compounds of the formula (I) 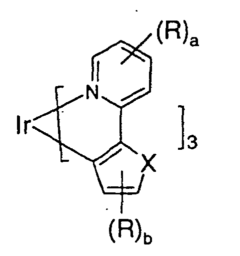 where
X is -CH=CH-, -CR=CH-, -CR=CR-, N-H, N-R¹, O, S or Se;
R is the same or different at each occurrence and is F, Cl, Br, NO₂, CN, a straight-chain or branched or cyclic alkyl or alkoxy group having from 1 to 20 carbon atoms, in each of which one or more nonadjacent CH₂ groups may be replaced by -O-, -S-, -NR¹-, or -CONR² -, and in each of which one or more hydrogen atoms may be replaced by F, or an aryl or heteroaryl group having from 4 to 14 carbon atoms which may be substituted by one or more nonaromatic radicals R; and a plurality of substituents R, either on the same ring or on the two different rings, may in turn together form a further mono- or polycyclic ring system;
R¹ and R² are the same or different and are each H or an aliphatic or aromatic hydrocarbon radical having from 1 to 20 carbon atoms,
a is 0, 1, 2, 3 or 4,
b is 0, 1 or 2,
by reacting a compound of the formula (Ia) 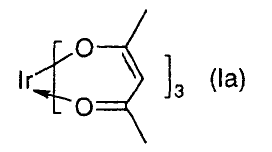 with a compound of the formula (Ib) 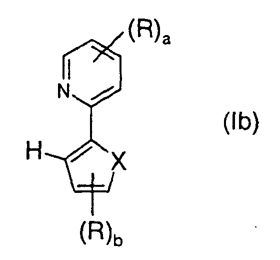 where the radicals X, R, a and b are each as defined in the formula (I) in a dipolar protic solvent, an etherified derivative derived therefrom or N-methylpyrrolidinone (NMP), at temperatures in the range from 160 to 220°C and a concentration of the iridium reactant (based on iridium) in the range from 0.05 to 1.00 mol/l, the concentration of the ligand used (aryl-pyridyl derivative) being a factor of from 4 to 20 higher than that of the iridium reactant, for a period of from 20 to 100 hours.

2. The process as claimed in claim 1, **characterized in that** the solvent used is ethylene glycol, propylene glycol, glycerol, PEG600, PEG1000, triethylene glycol dimethyl ether, poly(ethylene glycol) dimethyl ether or N-methylpyrrolidinone (NMP).

3. The process as claimed in claims 1 and/or 2, **characterized in that** the reaction is carried out within a temperature range of from 180°C to 210°C.

4. The process as claimed in one or more of claims 1 to 3, **characterized in that** the concentration of the iridium reactant, iridiurn(III) acetylacetonate or a similar 1,3-diketo chelate complex is in the range from 0.08 to 0.25 molar.

5. The process as claimed in one or more of claims 1 to 4, **characterized in that** the ratio of the iridium reactant, iridium(III) acetylacetonate or a similar 1,3-diketo chelate complex to the arylpyridyl derivative is from 1:6 to 1:15.

6. The process as claimed in one or more of claims 1 to 5, **characterized in that** the reaction is carried out within from 30 to 80 hours.

7. A process for preparing compounds of the formula (II) 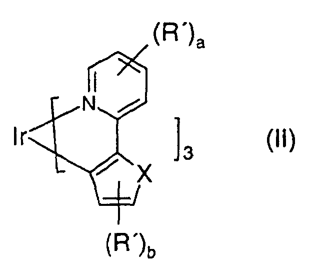 where
X is -CH=CH-, -CR=CH-, -CR=CR-, N-H, N-R¹, O, S or Se;
R' is the same or different at each occurence and is F, a straight-chain or branched or cyclic alkyl group having from 1 to 20 carbon atoms, in which one or more hydrogen atoms may be replaced by F, or an aryl group having from 6 to 14 carbon atoms which may be substituted by one or more nonaromatic radicals R'; and a plurality of substituents R', either on the same ring or on the two different rings, may in turn together form a further mono- or polycyclic ring system;
R¹ is in each case the same or different and is an aliphatic or aromatic hydrocarbon radical having from 1 to 20 carbon atoms,
a is 0, 1, 2, 3 or 4,
b is 0, 1 or 2,
by reacting a compound of the formula (IIb) 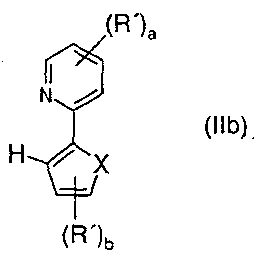 where the radicals X, R', a and b are as defined above with an organometallic lithium compound to give a compound of the formula (IIc) 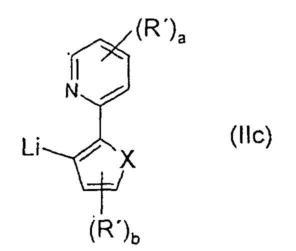 and subsequently reacting the compound of the formula (IIc) with an Ir(III) compound at low temperatures to give the target compound of the formula (II).

8. The process as claimed in claim 7, **characterized in that** iridium(III) chloride, tris-(pyridine)iridium(III) chloride and tris(tetrahydrothiophene)iridium(III) chloride are used.

9. The process as claimed in claims 7 and/or 8, **characterized in that** the 2'-lithio-2-arylpyridyl derivative of formula (IIc) is prepared in-situ.

10. The process as claimed in one or more of claims 7 to 9, **characterized in that** the reaction is carried out within the range from -110 to +10°C.

11. The process as claimed in claim 10, **characterized in that** the reaction is carried out within the range from -110 to -20°C.

12. The process as claimed in claim 10, **characterized in that** the reaction is carried out within the range from -90 to -40°C.

13. A compound of the formula (I) 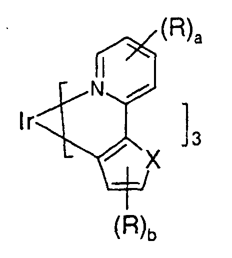 where
X is -CH=CH-, -CR=CH-, -CR=CR-, N-H, N-R¹, O, S or Se;
R is the same or different at each occurrence and is F, Cl, Br, NO₂, CN, a straight-chain or branched or cyclic alkyl or alkoxy group having from 1 to 20 carbon atoms, in each of which one or more nonadjacent CH₂ groups may be replaced by -O-, -S-, -NR¹-, or -CONR² -, and in each of which one or more hydrogen atoms may be replaced by F or an aryl or heteroaryl group having from 4 to 14 carbon atoms which may be substituted by one or more nonaromatic radicals R; and a plurality of substituents R, either on the same ring or on the two different rings, may in turn together form a further mono- or polycyclic ring system;
R¹ and R² are the same or different and are each H or an aliphatic or aromatic hydrocarbon radical having from 1 to 20 carbon atoms,
a is 0, 1, 2, 3 or 4,
b is 0, 1 or 2,
whose purity (determined by means of HPLC) is more than 99%.

14. A compound of the formula (II) 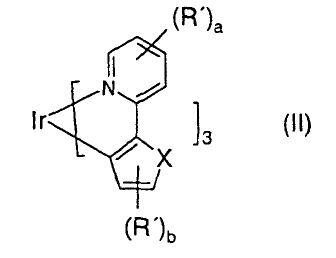 where
X is -CH=CH-, -CR=CH-, -CR=CR-, N-H, N-R¹, O, S or Se;
R' is the same or different at each occurrence and is F, a straight-chain or branched or cyclic alkyl group having from 1 to 20 carbon atoms, in which one or more hydrogen atoms may be replaced by F, or an aryl group having from 6 to 14 carbon atoms which may be substituted by one or more nonaromatic radicals R'; and a plurality of substituents R', either on the same ring or on the two different rings, may in turn together form a further mono- or polycyclic ring system;
R¹ is in each case the same or different and is an aliphatic or aromatic hydrocarbon radical having from 1 to 20 carbon atoms,
a is 0, 1, 2, 3 or 4,
b is 0, 1 or 2,
whose purify (determined by means of HPLC) is more than 99%.

## Revendications

1. Procédé de production de composés de formule (I) 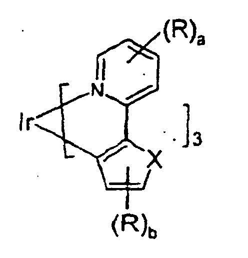 où
X est -CH=CH-, -CR=CH-, -CR=CR-, N-H, N-R¹, O, S ou Se ;
R est, identique ou différent à chaque occurrence, F, CI, Br, NO₂, CN, un groupe alkyle ou alcoxy linéaire ou ramifié ou cyclique ayant 1 à 20 atomes de carbone, où un ou plusieurs groupes CH₂ non voisins peuvent être remplacés par -O-, -S-, -NR¹- ou -CONR²- et où un ou plusieurs atomes H peuvent être remplacés par F, ou un groupe aryle ou hétéroaryle ayant 4 à 14 atomes de carbone, qui peut être substitué par un ou plusieurs groupements R non aromatiques ; où plusieurs substituants R, tant sur le même cycle que sur les deux cycles différents, peuvent couvrir ensemble de nouveau un autre système cyclique mono- ou polycyclique ;
R¹ et R² sont, identiques ou différents, H ou un groupement hydrocarboné aliphatique ou aromatique ayant 1 à 20 atomes de carbone,
a est 0, 1, 2, 3 ou 4,
b est 0,1 ou 2,
par réaction d'un composé de formule (Ia) 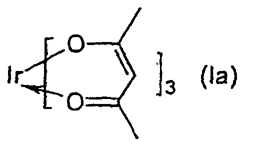 avec un composé de formule (Ib) 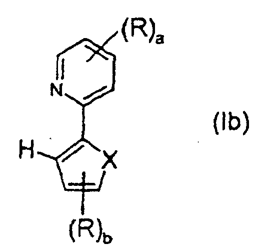 où les groupements X, R, a et b ont les significations citées pour la formule (I), dans un solvant protique dipolaire, un dérivé éthérifié issu de celui-ci ou la N-méthylpyrrolidinone (NMP), à des températures dans le domaine de 160 à 220°C et à une concentration du réactif contenant de l'iridium (par rapport à l'iridium) dans le domaine de 0,05 à 1,00 mol/l et où la concentration du ligand (dérivé aryl-pyridyle) utilisé est supérieure d'un facteur 4 à 20 à celle du réactif contenant de l'iridium pendant une durée de 20 à 100 heures.

2. Procédé selon la revendication 1 **caractérisé en ce que** l'éthylèneglycol, le propylèneglycol, la glycérine, le PEG 600, le PEG 1000, le diméthyléther de triéthylèneglycol, le poly-(éthylèneglycol)-diméthyléther ou la N-méthylpyrrolidinone (NMP) est utilisé comme solvant.

3. Procédé selon les revendications 1 et/ou 2 **caractérisé en ce que** la réaction est conduite dans un domaine de température de 180°C à 210°C.

4. Procédé selon une ou plusieurs des revendications 1 à 3 **caractérisé en ce que** la concentration du réactif contenant de l'iridium, l'acétylacétonate d'iridium (III) ou un complexe chélate 1,3-dicéto analogue, est située dans le domaine de 0,08 à 0,25 fois molaire.

5. Procédé selon une ou plusieurs des revendications 1 à 4 **caractérisé en ce que** le rapport du réactif contenant de l'iridium, l'acétylacétonate d'iridium (III) ou un complexe chélate 1,3-dicéto analogue, par rapport au dérivé aryl-pyridyle, est 1 : 6 à 1 : 15.

6. Procédé selon une ou plusieurs des revendications 1 à 5 **caractérisé en ce que** la réaction est conduite en 30 à 80 h.

7. Procédé de production de composés de formule (II) 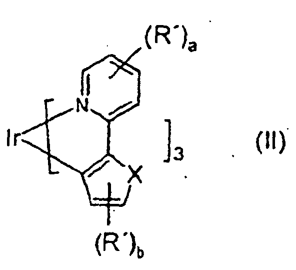 où
X est -CH=CH-, -CR=CH-, -CR=CR-, N-H, N-R¹, O, S ou Se ;
R' est, identique ou différent à chaque occurrence, F, un groupe alkyle linéaire ou ramifié ou cyclique ayant 1 à 20 atomes de carbone, où un ou plusieurs atomes H peuvent être remplacés par F, ou un groupe aryle ayant 6 à 14 atomes de carbone, qui peut être substitué par un ou plusieurs groupements R' non aromatiques ; où plusieurs substituants R', tant sur le même cycle que sur les deux cycles différents, peuvent couvrir ensemble de nouveau un autre système cyclique mono- ou polycyclique ;
R¹, identique ou différent, est un groupement hydrocarboné aliphatique ou aromatique ayant 1 à 20 atomes de carbone,
a est 0, 1, 2, 3 ou 4,
b est 0, 1 ou 2,
par réaction d'un composé de formule (IIb) 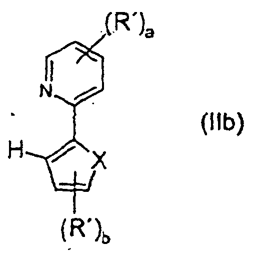 où les groupements X, R', a et b ont les significations citées précédemment, avec un composé organométallique du lithium en un composé de formule (IIc) 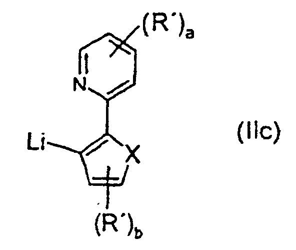 et réaction subséquente du composé de formule (IIc) avec un composé de Ir (III) à de basses températures en le composé cible de formule (II).

8. Procédé selon la revendication 7 **caractérisé en ce que** le chlorure d'iridium (III), le chlorure de tris-(pyridine)-iridium (III) et le chlorure de tris-(tétrahydrothiophène)-iridium (III) sont utilisés.

9. Procédé selon les revendications 7 et/ou 8 **caractérisé en ce que** le dérivé 2'-lithio-2-arylpyndyle selon la formule (IIc) est préparé « in situ ».

10. Procédé selon une ou plusieurs des revendications 7 à 9 **caractérisé en ce que** la réaction est conduite dans le domaine de -110 à +10°C.

11. Procédé selon la revendication 10 **caractérisé en ce que** la réaction est conduite dans le domaine de -110 à -20°C.

12. Procédé selon la revendication 10 **caractérisé en ce que** la réaction est conduite dans le domaine de -90 à -40°C.

13. Composés de formule (I) 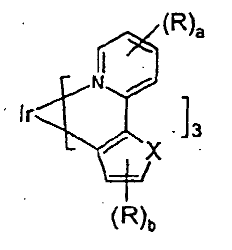 où
X est -CH=CH-, -CR=CH-, -CR=CR-, N-H, N-R¹, O, S ou Se ;
R est, identique ou différent à chaque occurrence, F, CI, Br, NO₂, CN, un groupe alkyle ou alcoxy linéaire ou ramifié ou cyclique ayant 1 à 20 atomes de carbone, où un ou plusieurs groupes CH₂ non voisins peuvent être remplacés par -O-, -S-, -NR¹- ou -CONR²- et où un ou plusieurs atomes H peuvent être remplacés par F, ou un groupe aryle ou hétéroaryle ayant 4 à 14 atomes de carbone, qui peut être substitué par un ou plusieurs groupements R non aromatiques ; où plusieurs substituants R, tant sur le même cycle que sur les deux cycles différents, peuvent couvrir ensemble de nouveau un autre système cyclique mono- ou polycyclique ;
R¹ et R² sont, identiques ou différents, H ou un groupement hydrocarboné aliphatique ou aromatique ayant 1 à 20 atomes de carbone,
a est 0, 1, 2, 3 ou 4,
b est 0, 1 ou 2,
dont la pureté (déterminée par CLHP) est supérieure à 99 %.

14. Composés de formule (II) 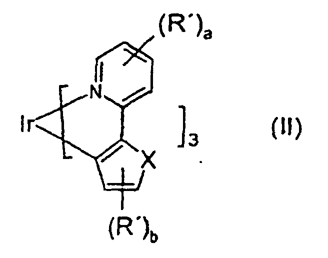 où
X est -CH=CH-, -CR=CH-, -CR=CR-, N-H, N-R¹, O, S ou Se ;
R' est, identique ou différent à chaque occurrence, F, un groupe alkyle linéaire ou ramifié ou cyclique ayant 1 à 20 atomes de carbone, où un ou plusieurs atomes H peuvent être remplacés par F, ou un groupe aryle ayant 6 à 14 atomes de carbone, qui peut être substitué par un ou plusieurs groupements R' non aromatiques ; où plusieurs substituants R', tant sur le même cycle que sur les deux cycles différents, peuvent couvrir ensemble de nouveau un autre système cyclique mono- ou polycyclique ;
R¹, identique ou différent, est un groupement hydrocarboné aliphatique ou aromatique ayant 1 à 20 atomes de carbone,
a est 0, 1, 2, 3 ou 4,
b est 0, 1 ou 2,
dont la pureté (déterminée par CLHP) est supérieure à 99 %.
